# DEMANDE DE BREVET EUROPEEN

(11) **EP 4 145 491 A1**
(43) Date de publication de la demande: **08.03.2023**
(21) Numéro de dépôt: 22193469.8
(22) Date de dépôt: 01.09.2022
(51) Int. Cl.: H01L 21/02, H01L 21/762

(54) **PROCÉDÉ DE FABRICATION D'UN CIRCUIT INTÉGRÉ**

(30) Priorité: 02.09.2021 FR 2109178
(71) Demandeur: Commissariat à l'énergie atomique et aux énergies alternatives, 75015 Paris (FR)
(72) Inventeur: FACHE, Thibaud, 38054 GRENOBLE CEDEX 09 (FR); MORAND, Yves, 38054 GRENOBLE CEDEX 09 (FR)
(74) Mandataire: Cabinet Camus Lebkiri

(57) **Abrégé**

Un aspect de l'invention concerne un procédé de fabrication d'un circuit intégré, comprenant les étapes suivantes :
- fournir un empilement comprenant un substrat (31) et une couche diélectrique (32) disposée sur le substrat, le substrat (31) étant formé d'un matériau semiconducteur présentant une résistivité supérieure ou égale à 500 Ω.cm ;
- graver des tranchées (40) s'étendant à travers la couche diélectrique (32) et débouchant sur le substrat (31) ;
- graver le substrat (31) de manière isotrope et sélective par rapport à la couche diélectrique (32) pour former des premières cavités (50) dans le substrat (31) ;
- déposer (S4) une couche de piégeage des charges électriques mobiles (60) sur des parois des premières cavités (50) et sur des parois latérales des tranchées (40), de manière à boucher les tranchées (40) dans la couche diélectrique (32), fermant ainsi les premières cavités (50) dans le substrat (31) ; et
- former des composants passifs à la verticale des premières cavités (50).

## Description

### DOMAINE TECHNIQUE

La présente invention est relative aux substrats semi-conducteurs utilisés pour fabriquer des circuits intégrés, et plus particulièrement des circuits radiofréquences (RF).

### ÉTAT DE LA TECHNIQUE

Différents types de substrat peuvent être utilisés pour fabriquer des circuits intégrés. Le substrat est généralement choisi en fonction du type de circuit à fabriquer : circuits radiofréquences (RF), circuits logiques à base de transistors MOS, capteurs d'images...

Parmi les substrats d'intérêt, on peut citer la structure multicouche silicium sur isolant ou SOI (pour « Silicon On Insulator » en anglais). La structure multicouche SOI comprend successivement une couche de support en silicium, une couche électriquement isolante, généralement une couche d'oxyde dite enterrée (ou couche BOX, pour « buried oxide layer » en anglais), et un film mince en silicium monocristallin, aussi appelé couche active. La couche active est ainsi nommée car elle est destinée à recevoir des composants actifs, typiquement des transistors MOS (acronyme de « Metal Oxide Semiconductor »). Le canal de conduction des transistors MOS est formé dans la couche active. La structure SOI offre notamment la possibilité de fabriquer des transistors complètement déplétés (ou FDSOI, pour « Fully Depleted SOI ») ou partiellement déplétés (ou PDSOI « Partially Depleted SOI »).

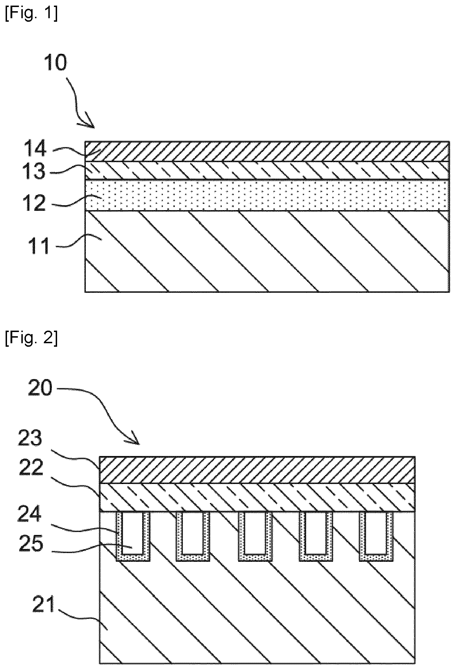

La figure 1 montre une autre structure multicouche 10, dérivée de la structure SOI et couramment utilisée pour la fabrication de circuits intégrés RF, tels que les modules d'émission-réception de signaux RF intégrés dans les téléphones portables (modules dits « front-end »).

Cette structure multicouche 10, appelée « TR-SOI », comprend successivement une couche de support 11 en silicium de haute résistivité, une couche riche en pièges (« trap-rich layer ») 12, une couche d'oxyde enterrée 13 et une couche active 14 en silicium monocristallin. La couche riche en pièges 12 empêche le phénomène de conduction parasite à l'interface entre la couche de support 11 et la couche d'oxyde enterrée 13, ce phénomène étant habituellement causé par des électrons libres qui s'accumulent à l'interface sous l'effet des charges positives fixes contenues dans la couche d'oxyde enterrée 13. Grâce à la couche riche en pièges 12, les électrons sont piégés et ne peuvent plus circuler. La résistivité effective de la couche de support 11 est ainsi augmentée par rapport à une structure multicouche dépourvue de couche riche en pièges (structure appelée « HR-SOI »). La couche riche en pièges 12 peut être constituée de silicium polycristallin. Les pièges sont situés aux joins de grain du silicium polycristallin.

La structure TR-SOI 10 améliore grandement les performances RF des circuits intégrés fabriqués à partir de cette structure, notamment en termes de linéarité et de diaphonie. Les éléments passifs (inductances, capacités...) formés au-dessus de la couche active 14 bénéficient quant à eux d'un meilleur facteur de qualité.

La figure 2 représente en vue de coupe schématique une autre structure multicouche 20 adaptée pour des applications radiofréquences et décrite dans le document WO2017/212160A1.

Cette structure multicouche 20 comprend successivement un substrat support 21 en silicium de haute résistivité, une couche diélectrique 22 en dioxyde de silicium disposée sur le substrat support 21, une couche active 23 en silicium monocristallin disposée sur la couche diélectrique 22 et des tranchées 24 s'étendant dans le substrat support 21 depuis l'interface entre le substrat support 21 et la couche diélectrique 22. Les parois des tranchées 24 sont tapissées d'un matériau 25 présentant des propriétés de piégeage des charges électriques mobiles. La partie restante des tranchées 24 est remplie par un gaz ou un mélange gazeux, par exemple d'air. Les tranchées sont ainsi conservées à l'état de cavités.

Grâce à ces cavités, la résistivité effective du substrat support 21 est encore augmentée.

La fabrication de la structure multicouche 20 comporte une étape de report de la couche diélectrique 22 et de la couche active 23 sur le substrat support 21. Ce report peut être accompli grâce à une technique de collage (direct ou par adhésion moléculaire) telle que le procédé Smart Cut^{™}. Il reste toutefois complexe à mettre en œuvre, car l'interface de collage n'est pas entièrement constituée de silicium. Plus particulièrement, le collage est rendu difficile par la présence des tranchées 24.

### RÉSUMÉ DE L'INVENTION

Il existe donc un besoin de prévoir un procédé de fabrication d'une structure multicouche munie de cavités qui soit plus simple à mettre en œuvre.

Selon un premier aspect de l'invention, on tend vers à satisfaire ce besoin en prévoyant un procédé de fabrication comprenant les étapes suivantes :
- fournir un empilement comprenant un substrat et une couche diélectrique disposée sur le substrat, le substrat étant formé d'un matériau semiconducteur présentant une résistivité supérieure ou égale à 500 Ω.cm ;
- graver des tranchées s'étendant à travers la couche diélectrique et débouchant sur le substrat ;
- graver le substrat de manière isotrope et sélective par rapport à la couche diélectrique pour former des premières cavités dans le substrat ; et
- déposer une couche de piégeage des charges électriques mobiles sur des parois des premières cavités et sur des parois latérales des tranchées, de manière à boucher les tranchées dans la couche diélectrique, fermant ainsi les premières cavités dans le substrat.

Dans un mode de mise en œuvre préférentiel du procédé de fabrication, l'empilement fourni comprend en outre une couche active disposée sur la couche diélectrique et une couche de protection disposée sur la couche active, la gravure des tranchées s'étendant en outre dans la couche active et dans la couche de protection.

Selon un développement de ce mode de mise en œuvre préférentiel, des deuxièmes cavités sont formées dans la couche active en même temps que les premières cavités dans le substrat, par gravure de la couche active de manière isotrope et sélective par rapport à la couche diélectrique et à la couche de protection, et dans lequel les deuxièmes cavités sont remplies par la couche de piégeage des charges électriques mobiles.

Le procédé selon le premier aspect de l'invention peut également présenter une ou plusieurs des caractéristiques ci-dessous, considérées individuellement ou selon toutes les combinaisons techniquement possibles :
- l'étape de fourniture de l'empilement comprend une opération d'oxydation thermique d'une surface du substrat, une opération de nitruration de la surface du substrat ou une opération de dépôt de la couche diélectrique sur le substrat ;
- le procédé comprend en outre une étape de retrait d'une portion de la couche de piégeage des charges électriques mobiles déposée sur la couche diélectrique ;
- les tranchées s'étendent en outre dans une partie du substrat ;
- chaque tranchée présente une largeur comprise entre 20 nm et 100 nm ;
- chaque tranchée présente une longueur comprise entre 50 µm et 2000 µm ;
- chaque tranchée présente une profondeur comprise entre 50 nm et 300 nm ;
- les tranchées sont de dimensions identiques ;
- les tranchées sont disjointes et s'étendent dans la couche diélectrique selon des plans parallèles entre eux et perpendiculaires à une face principale du substrat ;
- les tranchées sont espacées deux à deux d'une distance telle que les premières cavités fusionnent en une plus grande cavité lors de l'étape de gravure du substrat ;
- les tranchées sont espacées deux à deux d'une distance comprise entre 300 nm et 5000 nm ;
- les tranchées communiquent entre elles et forment un maillage dans la couche diélectrique ;
- les tranchées présentent un premier pas de répétition compris entre 100 nm et 5000 nm dans une première direction et un deuxième pas de répétition compris entre 100 nm et 5000 nm dans une deuxième direction sécante à la première direction ;
- chaque première cavité présente une largeur comprise entre 200 nm et 5000 nm ;
- chaque première cavité présente une longueur comprise entre 50 µm et 2000 µm ; et
- chaque première cavité présente une profondeur comprise entre 100 nm et 2500 nm ;
- les premières cavités sont de dimensions identiques.

Un deuxième aspect de l'invention concerne un procédé de fabrication d'un circuit intégré, comprenant les étapes suivantes :
- fabriquer une structure multicouche en accomplissant un procédé selon le premier aspect de l'invention ;
- former des composants passifs sur la structure multicouche, à la verticale des premières cavités.

Le procédé selon le deuxième aspect de l'invention peut également comprendre une ou plusieurs des étapes ci-dessous, considérées individuellement ou selon toutes les combinaisons techniquement possibles :
- une étape de formation de tranchées d'isolation électrique avant l'étape de gravure des tranchées ;
- une étape de formation de composants actifs dans une première zone de la structure multicouche, la première zone étant dépourvue de premières cavités, les composants passifs étant formés dans une deuxième zone de la structure multicouche, distincte de la première zone et munie des premières cavités ;
- une étape de retrait total de la couche diélectrique avant l'étape de formation des composants actifs ;
- une étape de formation d'au moins un niveau d'interconnexion électrique reliant les composants actifs, les composants passifs étant formés sur ledit au moins un niveau d'interconnexion électrique.

Un troisième aspect de l'invention concerne une structure multicouche comprenant :
- un substrat ;
- une couche diélectrique disposée sur le substrat ;
- des tranchées s'étendant à travers la couche diélectrique jusqu'au substrat ;
- des premières cavités s'étendant dans le substrat, depuis l'interface entre le substrat et la couche diélectrique ;
- une couche de piégeage des charges électriques mobiles remplissant entièrement les tranchées dans la couche diélectrique et tapissant des parois des premières cavités aménagées dans le substrat.

Dans un mode de réalisation préférentiel, la structure multicouche comprend en outre :
- une couche active disposée sur la couche diélectrique ;
- des deuxièmes cavités aménagées dans la couche active et remplies au moins partiellement par la couche de piégeage des charges électriques mobiles.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes :
- la figure 1, précédemment décrite, représente une structure multicouche selon l'art antérieur, pouvant être utilisée comme substrat de départ pour la fabrication de circuits intégrés radiofréquences ;
- la figure 2, précédemment décrite, représente une autre structure multicouche selon l'art antérieur, adaptée également aux applications radiofréquences ;
- les figures 3A à 3E représentent un premier mode de mise en œuvre du procédé de fabrication de structure multicouche selon le premier aspect de l'invention ;
- les figures 4A à 4E représentent un deuxième mode de mise en œuvre du procédé de fabrication de structure multicouche ;
- la figure 5 est une vue en 3D de la structure multicouche obtenue à l'issue du procédé des figures 4A à 4E ;
- les figures 6A à 6D représentent une variante de mise en œuvre du procédé de fabrication de structure multicouche selon les figures 4A à 4E ;
- la figure 7 est une vue en 3D de la structure multicouche obtenue à l'issue du procédé des figures 6A à 6D ; et
- la figure 8 représente une étape du procédé de fabrication de circuit intégré selon le deuxième aspect de l'invention.

Pour plus de clarté, les éléments identiques ou similaires sont repérés par des signes de référence identiques sur l'ensemble des figures.

### DESCRIPTION DÉTAILLÉE

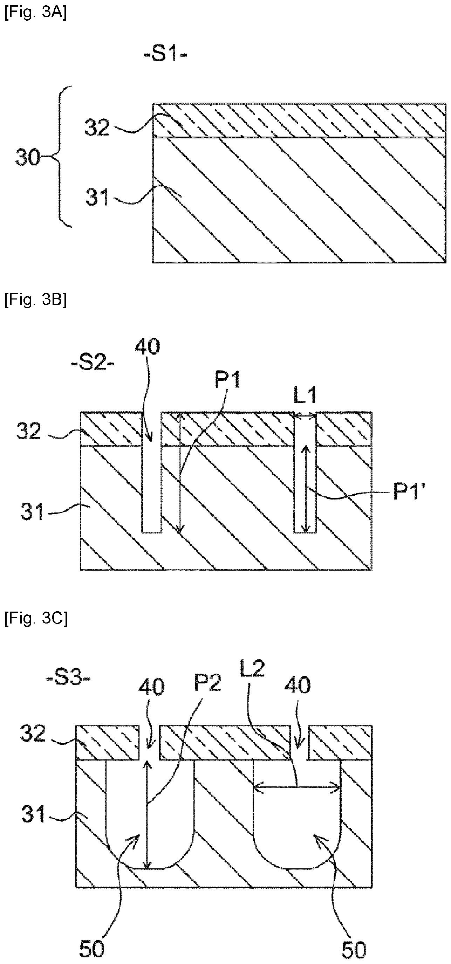

Les figures 3A à 3E représentent des étapes S1 à S5 d'un procédé de fabrication d'une structure multicouche 100, selon un premier mode de mise en œuvre de l'invention.

L'étape S1 de la figure 3A consiste à fournir un empilement 30 comprenant un substrat 31 et une couche diélectrique 32 disposée sur le substrat 31.

Le substrat 31, aussi appelé couche de support, est formé d'un matériau semi-conducteur de haute résistivité, par exemple du silicium haute résistivité. Un matériau semi-conducteur est ici qualifié de haute résistivité lorsque sa résistivité électrique est supérieure ou égale à 500 Ω.cm. Une telle résistivité permet de réduire les courants de fuite entre les différents composants (actifs ou passifs) formés sur le substrat et les courants de Foucault dans le substrat, limitant ainsi les pertes par effet Joule qui en découlent.

La couche diélectrique 32 est formé d'un matériau susceptible d'être gravé de manière sélective par rapport au matériau du substrat 31. La couche diélectrique 32 peut notamment être constituée d'un oxyde de silicium (par exemple le dioxyde de silicium, ou SiO₂) ou d'un nitrure de silicium (ex. Si₃N₄).

L'étape S1 de fourniture de l'empilement 30 comprend avantageusement une opération d'oxydation thermique (ou une opération de nitruration) de la surface du substrat 31 afin de former la couche diélectrique 32. Une interface de bonne qualité peut ainsi être obtenue. Alternativement, l'étape S1 de fourniture de l'empilement 30 peut comprendre une opération de dépôt de la couche diélectrique 32 sur le substrat 31, par exemple par dépôt chimique en phase vapeur assisté par plasma (ou PECVD, pour « plasma-enhanced chemical vapor déposition » en anglais) ou dépôt chimique en phase vapeur à basse pression (ou LPCVD, pour « low pressure chemical vapor déposition » en anglais).

Dans ce premier mode de mise en œuvre, le substrat 31 est un substrat dit « massif » (« bulk » en anglais), c'est-à-dire composé uniquement de matériau semi-conducteur (par opposition aux substrats innovants tels que le substrat SOI). L'épaisseur de la couche diélectrique 32 est de préférence comprise entre 50 nm et 100 nm.

La couche diélectrique 32 peut éventuellement être constituée d'un empilement de plusieurs sous-couches, par exemple une sous-couche d'oxyde de silicium surmontée d'une sous-couche de nitrure de silicium (intégration STI).

A l'étape S2 de la figure 3B, des tranchées 40 sont gravées à travers la couche diélectrique 32 jusqu'à atteindre le substrat 31. Ces tranchées 40 peuvent être formées grâce à une technique de gravure anisotrope, telle que la gravure ionique réactive (ou RIE, pour « reactive ionic etching » en anglais). Chaque tranchée 40 présente de préférence une largeur L1 comprise entre 20 nm et 100 nm, une longueur comprise entre 50 µm et 2000 µm et une profondeur P1 comprise entre 50 nm et 300 nm. La largeur L1, aussi appelée « dimension critique », est la plus petite dimension des tranchées 40 dans un plan parallèle à la face principale du substrat 31 (celle sur laquelle est disposée la couche diélectrique 32). Elle est ici mesurée dans le plan de coupe de la figure 3B. La longueur des tranchées 40 est mesurée perpendiculairement au plan de coupe de la figure 3B. La profondeur P1 des tranchées 40 est mesurée perpendiculairement à la face principale du substrat 31.

Avantageusement, les tranchées 40 s'étendent en outre dans une partie du substrat 31, comme cela est représenté sur la figure 3B. La profondeur P1' des tranchées 40 au sein du substrat 31 est de préférence comprise entre 50 nm et 200 nm.

A l'étape S3 de la figure 3C, des premières cavités 50 sont formées dans le substrat 31 en le gravant de manière isotrope et sélective par rapport à la couche diélectrique 32. Par exemple, un plasma CF₄/N₂/O₂ peut être utilisé pour graver (de manière isotrope) un substrat 31 en silicium sélectivement par rapport à une couche diélectrique 32 en SiO₂.

Les premières cavités 50 dans le substrat 31 communiquent avec les tranchées 40 dans la couche diélectrique 32. En effet, le substrat 31 est gravé en partant des tranchées 40. Lorsque celles-ci débouchent sur la face supérieure du substrat 31, les premières cavités 50 ont globalement la forme d'un demi-cylindre. Lorsque les tranchées 40 s'étendent en outre partiellement dans le substrat 31, les premières cavités 50 ont une forme plus allongée et s'étendent plus profondément dans le substrat 31.

De préférence, chacune des premières cavités 50 présente une largeur L2 comprise entre 200 nm et 5000 nm et une profondeur P2 comprise entre 100 nm et 2500 nm. La longueur des premières cavités 50 est sensiblement égale à la longueur des tranchées 40, par exemple comprise entre 50 µm et 2000 µm.

Les tranchées 40 peuvent avoir des dimensions identiques, bien que cela ne soit pas nécessaire à l'obtention des première cavités 50. De la même façon, les premières cavités 50 peuvent avoir des dimensions identiques (tel est le cas lorsque les tranchées 40 ont des dimensions identiques).

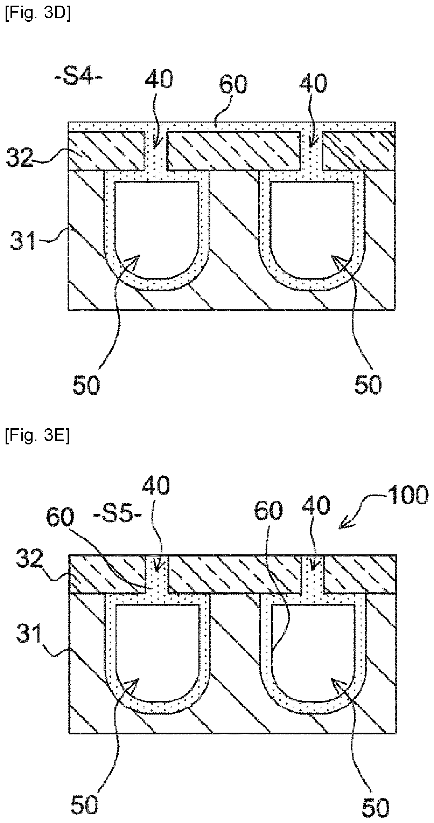

Ensuite, à l'étape S4 de la figure 3D, une couche de piégeage des charges électriques mobiles 60 est formée sur des parois des premières cavités 50 et sur des parois latérales des tranchées 40. Une couche de piégeage des charges électriques mobiles désigne une couche comprenant des pièges susceptibles de capturer des charges électriques mobiles.

La couche de piégeage 60 présente avantageusement une résistivité électrique supérieure à 50 Ω.cm pour des fréquences comprises entre 100 MHz et 100 GHz. Ainsi, la couche de piégeage 60 empêche ou limite significativement la propagation de signaux électriques dont la fréquence est comprise entre 100 MHz et 100 GHz.

La couche de piégeage 60 est déposée de manière à boucher les tranchées 40 dans la couche diélectrique 32, fermant ainsi les premières cavités 50 dans le substrat 31. De préférence, une technique de dépôt conforme telle que le dépôt chimique en phase vapeur à basse pression (ou LPCVD, pour « low pressure chemical vapor déposition » en anglais) est employée lors de l'étape S4. La couche de piégeage 60 est alors d'épaisseur constante, de préférence comprise entre 10 nm et 50 nm, et suit les contours du substrat 31 et de la couche diélectrique 32. En particulier, la couche de piégeage 60 recouvre toutes les parois latérales des tranchées 40 et toutes les parois des premières cavités 50. Elle s'étend également à la surface de la couche diélectrique 32.

En revanche, la couche de piégeage 60 ne remplit pas entièrement les premières cavités 50. La partie restante des premières cavités 50 est remplie d'un gaz ou d'un mélange gazeux, par exemple d'air ou d'autres gaz introduits dans le réacteur de dépôt. La pression qui règne dans les premières cavités 50 peut être très faible (elle est notamment fonction des pressions partielles des gaz introduits dans le réacteur de dépôt), afin d'arriver à une configuration de quasi-vide. Elle est de préférence comprise entre 1 Pa et 100 Pa.

La couche de piégeage 60 est de préférence formée d'un matériau présentant des propriétés de piégeage des charges électriques mobiles (électrons), tel que le silicium polycristallin.

Alternativement, la couche de piégeage 60 est en un matériau diélectrique, de préférence un oxyde tel que SiO₂ ou un nitrure tel que SiN.

Enfin, l'étape S5 de la figure 3E est une étape optionnelle consistant à retirer la portion de la couche de piégeage 60 déposée sur la couche diélectrique 32. Ce retrait peut être accompli par gravure, par exemple au moyen d'un plasma, ou par polissage mécano-chimique (CMP).

Ainsi, en référence à la figure 3E, la structure multicouche 100 comprend :
- le substrat 31 ;
- la couche diélectrique 32 disposée sur le substrat 31 ;
- les tranchées 40 s'étendant à travers la couche diélectrique 32 jusqu'au substrat 31 ;
- les premières cavités 50 s'étendant dans le substrat 31, depuis l'interface entre le substrat 31 et la couche diélectrique 32 ;
- la couche de piégeage 60 remplissant entièrement les tranchées 40 dans la couche diélectrique 32 et tapissant des parois des premières cavités 50 aménagées dans le substrat 31 (sans toutefois les remplir entièrement).

Comme il est connu dans le domaine des structures multicouches SOI pour les applications radiofréquences, une couche diélectrique (par exemple en SiO₂) sur un substrat semi-conducteur comporte des charges positives. Ces charges sont compensées par des charges négatives venant du substrat, au niveau de l'interface avec la couche diélectrique. Ces charges génèrent une couche de conduction parasite de surface (PSC) dans le substrat sous la couche diélectrique, ce qui diminue la résistivité effective du substrat. Les performances électriques sensibles à la résistivité du substrat (comme la linéarité du signal, le niveau de pertes d'insertion, les facteurs de qualité des composants passifs...) sont donc fortement dégradées par la présence de cette couche de conduction.

Les premières cavités 50 et la couche de piégeage 60 (lorsque cette dernière n'est pas en matériau diélectrique) limitent la surface sur laquelle les charges électriques mobiles s'accumulent. En outre, elles empêchent le mouvement de ces charges électriques dans le substrat 31 à l'interface avec la couche diélectrique 32. Les charges électriques sont obligées de contourner les premières cavités 50, traversant ainsi des zones du substrat 31 de plus forte résistivité (plus les premières cavités 50 sont profondes, plus cet effet de contournement est prononcé). Il en résulte que la résistivité effective du substrat 31 est grandement améliorée.

Les bouchons formés par la couche de piégeage 60 à travers la couche diélectrique 32 et la présence de la couche de piégeage 60 sur le plafond des premières cavités 50 sont des éléments reconnaissables du procédé de fabrication de structure multicouche selon l'invention.

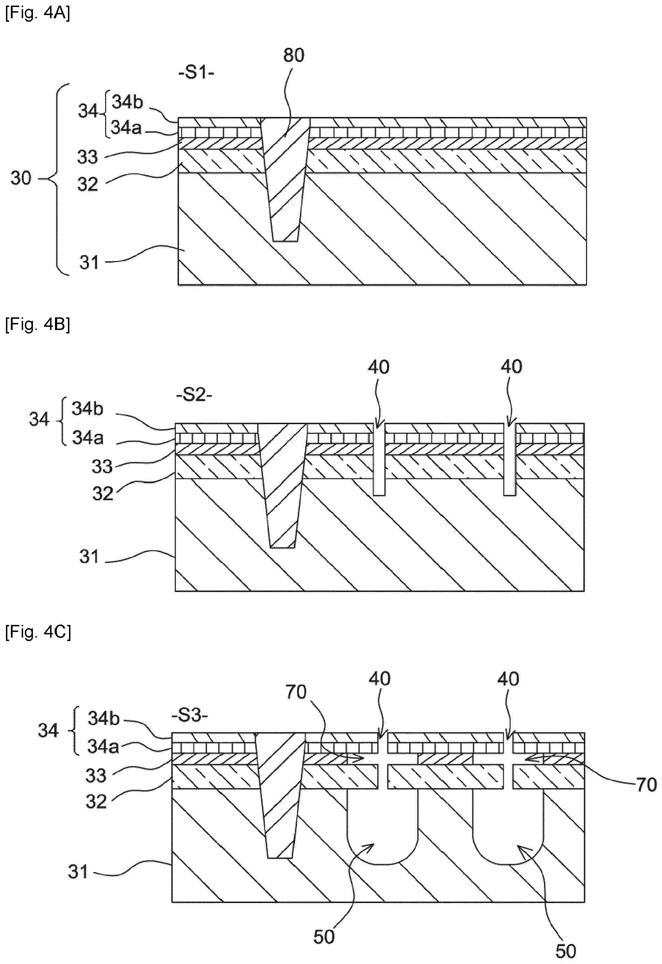

Les figures 4A à 4E représentent un deuxième mode de mise en œuvre du procédé de fabrication de structure multicouche. Ce deuxième mode de mise en œuvre diffère du premier mode de mise en œuvre (Figs.3A-3E) principalement dans le type de substrat utilisé comme point de départ du procédé de fabrication : un substrat de type SOI plutôt qu'un substrat massif.

Ainsi, l'empilement 30 fourni à l'étape S1 de la figure 4A comprend, outre le substrat (ou couche de support) 31 en matériau semi-conducteur de haute résistivité et la couche diélectrique 32, une couche active 33 disposée sur la couche diélectrique 32 et une couche de protection 34 disposée sur la couche active 33.

La couche active 33 est de préférence un film mince de matériau semi-conducteur, intrinsèque ou dopé, par exemple en silicium monocristallin, en germanium, en alliage de silicium-germanium ou en un matériau semi-conducteur III-V. La couche active 33 est plus particulièrement destinée à la fabrication de composants actifs, typiquement des transistors. Son épaisseur est de préférence comprise entre 6 nm et 200 nm.

La couche de protection 34 a pour but de protéger la couche active 33 lors des étapes ultérieures du procédé de fabrication de la structure multicouche. Elle peut également servir de couche de masque dur et/ou de couche d'arrêt de gravure lors d'un procédé de fabrication d'un circuit intégré à partir de la structure multicouche. La couche de protection 34 peut comporter plusieurs sous-couches superposées, par exemple une première sous-couche 34a en SiO₂ et une deuxième sous-couche 34b en SiN disposée sur la première sous-couche 34a.

La couche diélectrique 32 constitue la couche électriquement isolante du substrat SOI (appelée aussi couche d'oxyde enterrée ou BOX, dans le cas d'un oxyde tel que le SiO₂). Dans ce deuxième mode de mise en œuvre, l'épaisseur de la couche diélectrique 32 est avantageusement comprise entre 20 nm et 400 nm.

Après l'étape S2 de gravure des tranchées 40 représentée par la figure 4B, les tranchées 40 s'étendent à travers la couche active 33 et la couche de protection 34 (en plus de la couche diélectrique 32 et, éventuellement, une partie du substrat 31).

La figure 4C représente l'étape S3 de gravure du substrat 31, permettant la formation des premières cavités 50. Lorsque le matériau du substrat 31 et le matériau de la couche active 33 sont de même nature (par exemple du silicium), ou plus généralement lorsqu'ils sont tous les deux sensibles à la chimie de gravure employée à l'étape S3, la couche active 33 est en outre gravée et des deuxièmes cavités 70 sont formées dans la couche active 33 en même temps que les premières cavités 50 dans le substrat 31. La gravure est isotrope et sélective par rapport à la couche diélectrique 32 et à la couche de protection 34.

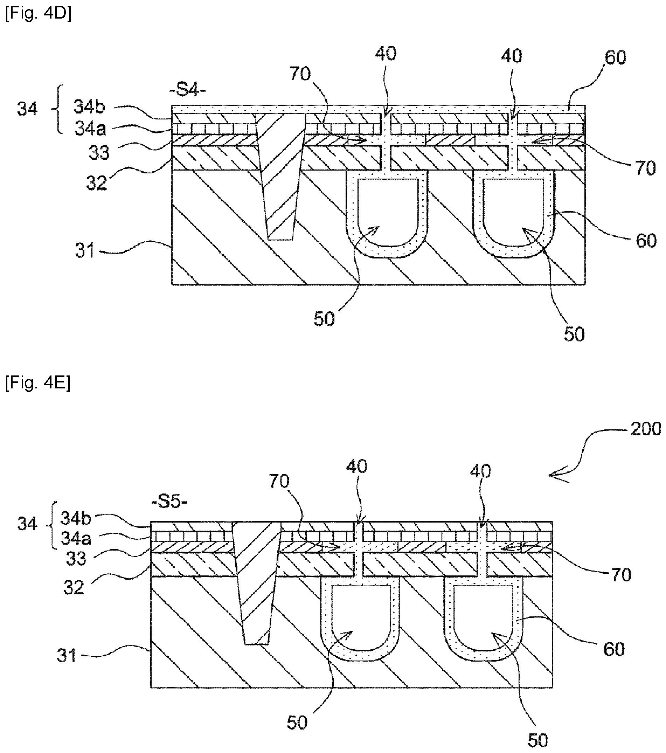

La figure 4D représente l'étape S4 de dépôt de la couche de piégeage 60. En plus de remplir entièrement les tranchées 40 et recouvrir les parois des premières cavités 50, la couche de piégeage 60 remplit les deuxièmes cavités 70 dans la couche active 33. Les deuxièmes cavités 70 sont de préférence remplies entièrement par la couche de piégeage 60.

Enfin, la portion supérieure de la couche de piégeage 60 (déposée sur la couche de protection 34) est retirée à l'étape S5 représentée par la figure 4E. Tout ou partie de la couche de protection 34 peut être également retiré au cours de cette étape S5. Par exemple, la deuxième sous-couche 34b en SiN peut être retirée (par gravure sélective ou CMP).

La structure multicouche 200 obtenue à l'issue du procédé de fabrication selon le deuxième mode de mise en œuvre (Fig.4E) comprend, en plus des éléments de la structure électronique 100 (Fig.3E), la couche active 33, les deuxièmes cavités 70 remplies partiellement ou entièrement de la couche de piégeage 60, et éventuellement la couche de protection 34.

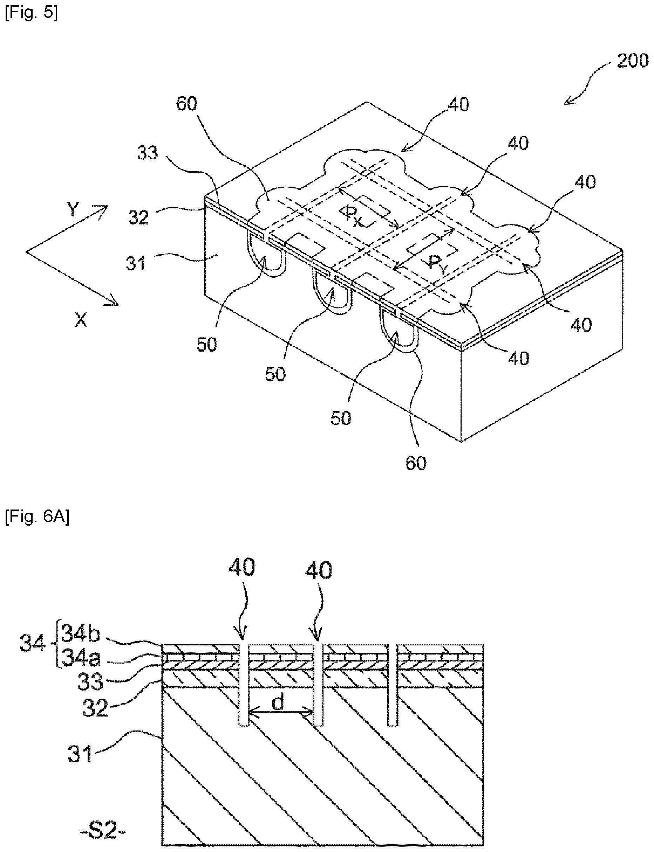

La figure 5 est une vue 3D de la structure multicouche 200 après avoir retiré entièrement la couche de protection 34. Cette figure montre que les premières cavités 50 peuvent former un réseau de galeries qui communiquent entre elles. Plus particulièrement, une première partie des premières cavités 50 peuvent s'étendre dans une première direction X et une deuxième partie des premières cavités 50 peuvent s'étendre dans une deuxième direction Y sécante (c.-à-d. non parallèle) à la première direction X.

Une telle structure multicouche 200 est obtenue en gravant à l'étape S2 des tranchées 40 qui communiquent entre elles et forment un maillage dans la couche diélectrique 32. De préférence, les tranchées 40 présentent un premier pas de répétition (appelé aussi période spatiale) Px compris entre 100 nm et 5 µm dans la première direction X et un deuxième pas de répétition P_{Y} compris entre 100 nm et 5 µm dans la deuxième direction Y. A titre d'exemple, les tranchées 40 forment un maillage rectangulaire (deuxième direction Y perpendiculaire à la première direction X). Le premier pas de répétition Px peut être égal au deuxième pas de répétition P_{Y} (maillage carré).

Dans une variante de mise en œuvre non représentée par les figures, les tranchées 40 sont disjointes et s'étendent toutes selon des plans parallèles entre eux et perpendiculaires à la face principale du substrat 31. Elles peuvent en outre présenter un pas de répétition Px dans la première direction X, de préférence compris entre 50 nm et 5 µm. Les premières cavités 50 s'étendent alors toutes parallèlement les unes aux autres dans la deuxième direction Y.

Les figures 6A à 6D représentent les étapes S2 à S5 selon une variante de mise en œuvre du procédé de fabrication de structure multicouche. Cette variante est applicable au cas d'un substrat massif et au cas d'un substrat SOI.

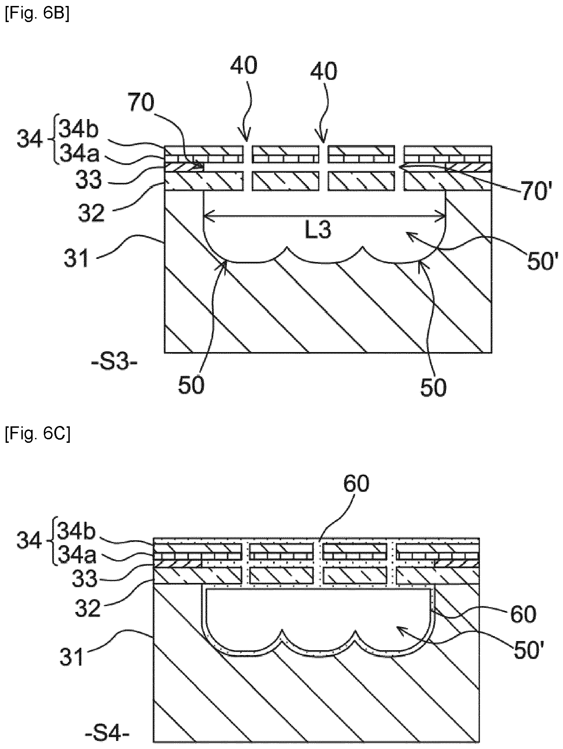

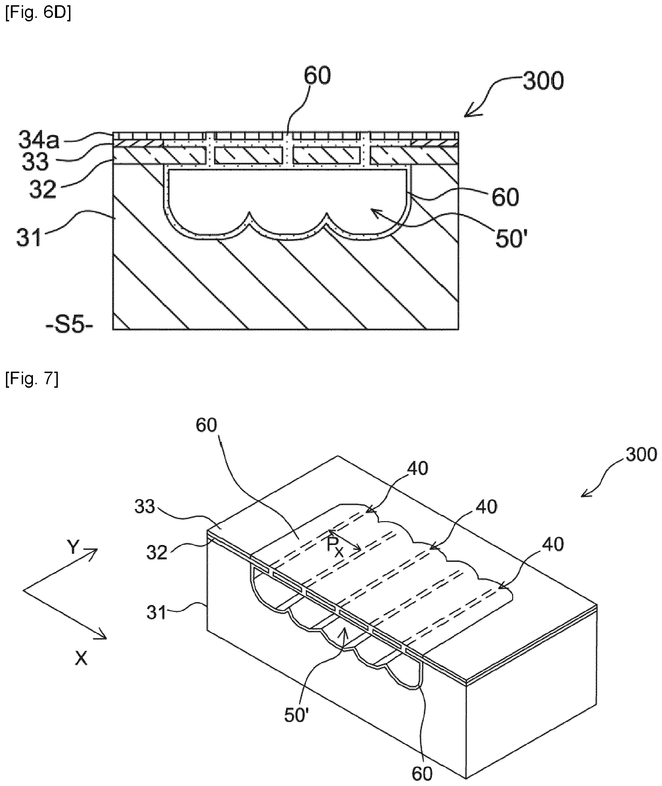

Dans cette variante de mise en œuvre, les tranchées 40 s'étendent parallèlement les unes aux autres (par exemple dans la deuxième direction Y). En outre, la distance d entre deux tranchées 40 consécutives (mesurée dans la première direction X ; cf. Fig.6A) et les conditions de la gravure isotrope et sélective (chimie, durée...) de l'étape S3 (Fig.6B) sont choisies de sorte que les premières cavités 50 fusionnent en une première grande cavité 50'. Le plafond de cette première grande cavité 50', constituée par des portions de la couche diélectrique 32, est tenu par les extrémités (situées dans des plans parallèles au plan de coupe de la figure 6B). Dans le cas d'un substrat SOI, les deuxièmes cavités 70 fusionnent également en une deuxième grande cavité 70'. Les étapes S4 et S5 du procédé de fabrication (cf. Fig.6C et Fig.6D) sont ensuite accomplies de la façon décrite en relation avec les figures 3D-3E ou 4D-4E.

La figure 6D représente en vue de coupe la structure multicouche 300 obtenue à l'issue de cette variante de mise en œuvre (avec la première sous-couche de protection 34a).

La figure 7 représente la même structure multicouche 300 en 3D (mais sans la première sous-couche de protection 34a). Avantageusement, les tranchées 40 présentent un pas de répétition Px dans la première direction X, de préférence compris entre 300 nm et 5 µm.

Ainsi, grâce à un espacement plus important des tranchées 40 (et donc une plus grande période spatiale), une cavité plus large peut être obtenue dans le substrat 31. La distance d entre deux tranchées 40 consécutives est avantageusement comprise entre 300 nm et 5000 nm. Cette distance d peut varier d'une paire de tranchées 40 à l'autre. Autrement dit, il n'est pas nécessaire que les tranchées 40 soient régulièrement espacées (ni qu'elles présentent des dimensions identiques) pour obtenir la première grande cavité 50'.

De préférence, la première grande cavité 50' présente une largeur L3 comprise entre 5 µm et 20 µm. Sa longueur et sa profondeur peuvent être respectivement identiques à la longueur et à la profondeur P2 des premières cavités 50 lorsqu'elles sont disjointes (respectivement entre 50 µm et 2000 µm et entre 100 nm et 2500 nm).

En prévoyant plusieurs groupes de tranchées 40 (espacées ou non de manière régulière), il est possible d'obtenir dans le substrat 31 plusieurs premières grandes cavités 50' distinctes (c.-à-d. non communicantes).

Le procédé de fabrication de structure multicouche décrit ci-dessus en relation avec les figures 3A-3E, 4A-4E et 6A-6D est simple à mettre en œuvre et facilement reproductible, car il ne fait appel qu'à des techniques maitrisées de l'industrie microélectronique (photolithographie, dépôt, gravure et CMP). Il ne comporte aucune étape de report ou de collage, qui peut être compliquée si la surface est structurée. Il permet en outre de réaliser des configurations variées de structure multicouche munie de cavités (ces configurations étant indépendantes des composants électroniques pouvant être formés ultérieurement sur la structure multicouche).

Par ailleurs, il peut être aisément intégré à un procédé de fabrication d'un circuit intégré, par exemple de type radiofréquence. Les étapes S2 à S5 peuvent notamment être accomplies immédiatement après avoir formé des tranchées d'isolation électrique 80 appelées STI (pour « Shallow Trench Isolation » en anglais) dans le substrat SOI (cf. Fig.4A) ou le substrat massif (recouvert de la couche diélectrique 32). La couche de masque dur ayant servi à former les STI 80 peut être conservée pour former tout ou partie de la couche de protection 34 du deuxième mode de mise en œuvre (et plus particulièrement la deuxième sous-couche 34b en SiN).

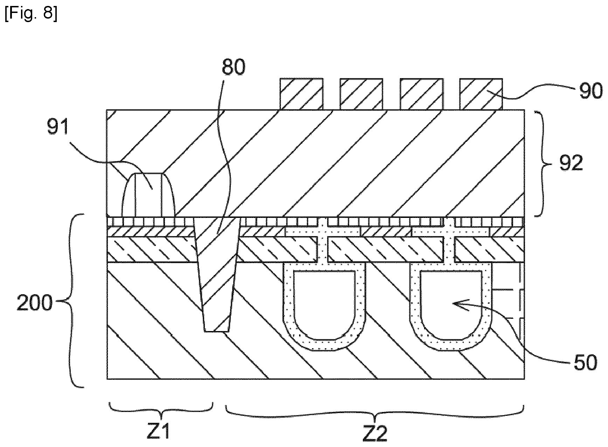

La figure 8 représente une étape du procédé de fabrication de circuit intégré. Après formation de la structure multicouche 100, 200 ou 300, le procédé de fabrication du circuit intégré 400 comprend une étape de formation de composants passifs 90 sur la structure multicouche. Avant l'étape de formation des composants passifs 90, le procédé de fabrication du circuit intégré 400 peut également comprendre une étape de formation de composants actifs 91 sur la structure multicouche et une étape de formation d'un ou plusieurs niveaux d'interconnexion électrique 92 reliant les composants actifs 91.

Les composants actifs 91 sont par exemple des transistors. Ils sont de préférence formés dans la couche active 33 du substrat SOI ou en surface du substrat massif 31, autrement dit dans la partie dite FEOL (« front-end of line » en anglais) du circuit intégré 400. Dans le cas d'un substrat massif, la couche diélectrique 32 est entièrement retirée avant de former les composants actifs 91 à la surface du substrat.

Les composants passifs 90 sont par exemples des bobines, des condensateurs, des résistances.... Ils sont situés à la verticale des premières cavités 50 dans le substrat 31 afin d'optimiser leurs performances électriques. Ils sont de préférence formés au-dessus des niveaux d'interconnexion électrique 92 (ou niveaux métalliques). A l'instar des niveaux d'interconnexion électrique 92, les composants passifs 90 appartiennent à la partie dite BEOL (« back-end of line » en anglais) du circuit intégré 400.

Les composants actifs 91 peuvent être formés dans une première zone Z1 de la structure multicouche, tandis que les composants passifs 90 sont formées dans une deuxième zone Z2. La deuxième zone Z2 est distincte de la première zone Z1 et munie des premières cavités 50. Les première et deuxième zones Z1-Z2 sont de préférence séparées par une tranchée d'isolation électrique 80.

## Revendications

1. Procédé de fabrication d'un circuit intégré (400), comprenant les étapes suivantes :
- fabriquer une structure multicouche (100, 200, 300) en accomplissant les étapes suivantes :
∘ fournir (S1) un empilement (30) comprenant un substrat (31) et une couche diélectrique (32) disposée sur le substrat, le substrat (31) étant formé d'un matériau semiconducteur présentant une résistivité supérieure ou égale à 500 Ω.cm ;
∘ graver (S2) des tranchées (40) s'étendant à travers la couche diélectrique (32) et débouchant sur le substrat (31) ;
∘ graver (S3) le substrat (31) de manière isotrope et sélective par rapport à la couche diélectrique (32) pour former des premières cavités (50) dans le substrat (31) ; et
∘ déposer (S4) une couche de piégeage des charges électriques mobiles (60) sur des parois des premières cavités (50) et sur des parois latérales des tranchées (40), de manière à boucher les tranchées (40) dans la couche diélectrique (32), fermant ainsi les premières cavités (50) dans le substrat (31) ;
- former des composants passifs (90) sur la structure multicouche (100, 200, 300), à la verticale des premières cavités (50).

2. Procédé selon la revendication 1, comprenant en outre une étape (S5) de retrait d'une portion de la couche de piégeage des charges électriques mobiles (60) déposée sur la couche diélectrique (32).

3. Procédé selon l'une des revendications 1 et 2, dans lequel l'empilement (30) fourni comprend une couche active (33) disposée sur la couche diélectrique (32) et une couche de protection (34) disposée sur la couche active (33), la gravure des tranchées (40) s'étendant en outre dans la couche active (33) et dans la couche de protection (34).

4. Procédé selon la revendication 3, dans lequel des deuxièmes cavités (70) sont formées dans la couche active (33) en même temps que les premières cavités (50) dans le substrat (31), par gravure de la couche active (33) de manière isotrope et sélective par rapport à la couche diélectrique (32) et à la couche de protection (34), et dans lequel les deuxièmes cavités (70) sont remplies par la couche de piégeage des charges électriques mobiles (60).

5. Procédé selon l'une quelconque des revendications 1 à 4, dans lequel les tranchées (40) sont disjointes et s'étendent dans la couche diélectrique (32) selon des plans parallèles entre eux et perpendiculaires à une face principale du substrat (31).

6. Procédé selon la revendication 5, dans lequel les tranchées (40) sont espacées deux à deux d'une distance (d) telle que les premières cavités (50) fusionnent en une plus grande cavité (50') lors de l'étape (S3) de gravure du substrat (31).

7. Procédé selon l'une quelconque des revendications 1 à 4, dans lequel les tranchées (40) communiquent entre elles et forment un maillage dans la couche diélectrique (32).

8. Procédé selon la revendication 7, dans lequel les tranchées présentent un premier pas de répétition (Px) compris entre 100 nm et 5000 nm dans une première direction (X) et un deuxième pas de répétition (P_{Y}) compris entre 100 nm et 5000 nm dans une deuxième direction (Y) sécante à la première direction (X).

9. Procédé selon l'une quelconque des revendications 1 à 8, comprenant en outre une étape de formation de tranchées d'isolation électrique (80) avant l'étape (S2) de gravure des tranchées (40).

10. Procédé selon l'une quelconque des revendications 1 à 9, comprenant en outre une étape de formation de composants actifs (91) dans une première zone (Z1) de la structure multicouche (100, 200, 300), la première zone (Z1) étant dépourvue de premières cavités (50), les composants passifs (90) étant formés dans une deuxième zone (Z2) de la structure multicouche, distincte de la première zone (Z1) et munie des premières cavités (50).

11. Procédé selon la revendication 10, comprenant en outre une étape de formation d'au moins un niveau d'interconnexion électrique (92) reliant les composants actifs (91), les composants passifs (90) étant formés sur ledit au moins un niveau d'interconnexion électrique (92).

12. Circuit intégré (400) comprenant :
- une structure multicouche (100, 200, 300) comprenant :
∘ un substrat (31) formé d'un matériau semiconducteur présentant une résistivité supérieure ou égale à 500 Ω.cm ;
∘ une couche diélectrique (32) disposée sur le substrat (31) ;
∘ des tranchées (40) s'étendant à travers la couche diélectrique (32) jusqu'au substrat (31) ;
odes premières cavités (50) s'étendant dans le substrat (31), depuis l'interface entre le substrat (31) et la couche diélectrique (32) ; et
∘ une couche de piégeage des charges électriques mobiles (60) tapissant des parois des premières cavités (50) aménagées dans le substrat (31) et remplissant entièrement les tranchées (40) dans la couche diélectrique (32), fermant ainsi les premières cavités (50) dans le substrat (31) ;
- des composants passifs (90) disposés sur la structure multicouche (100, 200, 300), à la verticale des premières cavités (50).

13. Circuit intégré (400) selon la revendication 12, dans lequel la structure multicouche (200, 300) comprend en outre :
- une couche active (33) disposée sur la couche diélectrique (32) ;
- des deuxièmes cavités (70) aménagées dans la couche active (33) et remplies au moins partiellement par la couche de piégeage des charges électriques mobiles (60).
